(19) Europäisches Patentamt
European Patent Office
Office européen des brevets

(11) **EP 2 369 743 B1**

(12) **FASCICULE DE BREVET EUROPEEN**

(45) Date de publication et mention
de la délivrance du brevet:
**23.05.2012 Bulletin 2012/21**

(51) Int Cl.:
***H03H 11/12*** *(2006.01)* ***H03H 11/04*** *(2006.01)*

(21) Numéro de dépôt: **11158316.7**

(22) Date de dépôt: **15.03.2011**

(54) **Circuit passe-bas du second ordre**

Tiefpassfilter der zweiten Ordnung

Second order low-pass filter

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.03.2010 FR 1052229**

(43) Date de publication de la demande:
**28.09.2011 Bulletin 2011/39**

(73) Titulaire: **STmicroelectronics SA**
**92120 Montrouge (FR)**

(72) Inventeur: **Blanc, Jean-Pierre**
**38570 Theys (FR)**

(74) Mandataire: **de Beaumont, Michel**
**1bis, rue Champollion**
**38000 Grenoble (FR)**

(56) Documents cités:
**EP-A1- 0 274 784      EP-A1- 1 764 919**
**US-A1- 2004 155 702**

- **ARONHIME P B ET AL: "Conversion of voltage-mode biquads to current-mode", CIRCUITS AND SYSTEMS, 1995., PROCEEDINGS., PROCEEDINGS OF THE 38TH MID WEST SYMPOSIUM ON RIO DE JANEIRO, BRAZIL 13-16 AUG. 1995, NEW YORK, NY, USA,IEEE, US, vol. 2, 13 août 1995 (1995-08-13), pages 1054-1057, XP010165310, DOI: DOI:10.1109/MWSCAS. 1995.510275 ISBN: 978-0-7803-2972-0**

EP 2 369 743 B1

**EP 2 369 743 B1**

**Description**

Domaine de l'invention

La présente invention concerne un filtre passe-bas. Plus particulièrement, la présente invention concerne un filtre passe-bas du second ordre.

Exposé de l'art antérieur

Des filtres passe-bas ou passe-haut d'ordres élevés sont généralement constitués d'une association série de plusieurs filtres du second ordre. En effet, il est plus facile de réaliser plusieurs filtres du second ordre qu'un unique filtre d'ordre plus élevé.
Pour obtenir des filtres du second ordre, de nombreuses structures sont connues. Un exemple de ces structures de filtre est connu sous l'appellation "filtre Sallen-Key". Les filtres Sallen-Key sont des sources de tension contrôlées en tension (VCVS). En modifiant les impédances constituant ces filtres, on obtient des filtres passe-bas ou passe-haut.

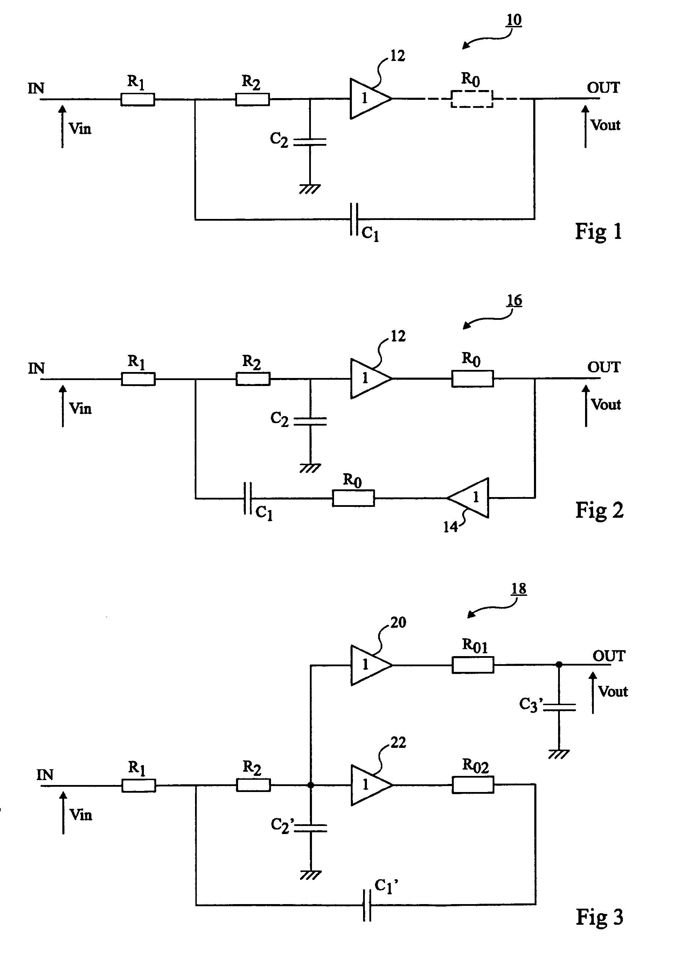

La figure 1 illustre un filtre passe-bas 10 du second ordre de type Sallen-Key.
Le filtre 10 comprend une borne d'entrée IN recevant une tension d'entrée $V_{in}$ et une borne de sortie OUT fournissant une tension de sortie $V_{out}$. Une première résistance $R_1$, une seconde résistance $R_2$ et un amplificateur de tension 12 de gain unitaire (appelé communément, et dans la suite de ce texte, "buffer") sont connectés en série entre la borne IN et la borne OUT. Les résistances $R_1$ et $R_2$ ont une même valeur R. Entre la borne de sortie OUT et le point de connexion entre les première et seconde résistances $R_1$ et $R_2$, est placé un condensateur $C_1$ et, entre la borne d'entrée du buffer 12 et une borne de masse, est placé un condensateur $C_2$.
Un circuit idéal tel que celui décrit ci-dessus présente une fonction de transfert T du second ordre, de type :

$$T = \frac{Vout}{Vin} = \frac{1}{1+\frac{1}{Q}\left(\frac{j\omega}{\omega_0}\right)+\left(\frac{j\omega}{\omega_0}\right)^2},$$

avec

$$f_0 = \frac{\omega_0}{2\pi} = \frac{1}{2\pi R\sqrt{C_1.C_2}} \quad \text{et} \quad Q = \frac{1}{2}\sqrt{\frac{C_1}{C_2}}.$$

Le buffer 12 peut être obtenu de plusieurs façons. Il peut notamment être constitué d'un amplificateur opérationnel présentant un gain unitaire ou d'un circuit émetteur suiveur (en technologie bipolaire) ou d'un circuit source suiveuse (en technologie CMOS). Cependant, quelle que soit la structure du circuit du buffer 12, celle-ci présente une impédance de sortie non nulle (représentée en figure 1 par une résistance $R_0$, en pointillés, en série entre la sortie du buffer 12 et le condensateur $C_1$). On considèrera ici uniquement des buffers dont l'impédance de sortie est résistive.
Dans le cas où le buffer 12 présente une impédance de sortie résistive de valeur $R_0$ non nulle, la fonction de transfert du circuit de la figure 1 devient :

$$T = \frac{1+j\omega(R_0.C_1)+(j\omega)^2(R.R_0.C_1.C_2)}{1+j\omega(2R.C_2+R_0C_1)+(j\omega)^2(R^2C_1.C_2+2R.R_0.C_1.C_2)}.$$

Cette fonction de transfert n'est plus du second ordre. De plus, elle a l'inconvénient, pour des fréquences élevées, de tendre vers une valeur fixe égale à $R_0/(R+2R_0)$. Ainsi, les signaux à haute fréquence ne sont pas suffisamment atténués.
On a déjà proposé de modifier le circuit du buffer 12 en lui ajoutant des éléments pour diminuer l'impédance de sortie du dispositif. Cependant, cette baisse de l'impédance de sortie ne peut se faire qu'en rendant la structure du circuit du buffer plus complexe, et donc en augmentant son coût et sa puissance consommée.
L'article "Eliminate Sallen-Key stopband leakage with a voltage follower", de Martin Cano - National Semicon-

2

ductor, EDN, publié en mai 2009, propose de modifier la structure du filtre Sallen-Key pour diminuer l'influence de la résistance de sortie.

La figure 2 représente un exemple de filtre 16 exposé dans cet article.

Le filtre 16 reprend l'ensemble des éléments du circuit 10 de la figure 1, l'impédance de sortie du buffer 12, résistive, étant appelée $R_0$. Il comprend en outre, entre la borne de sortie OUT et le condensateur $C_1$, un second buffer 14 dont l'impédance de sortie est résistive, également de valeur $R_0$.

Ce circuit a une fonction de transfert de la forme suivante :

$$T = \frac{1 + j\omega(R_0.C_1)}{1 + j\omega(2R.C_2 + R_0 C_1) + (j\omega)^2\left(R^2 C_1.C_2 + 2R.R_0.C_1.C_2\right)} \; .$$

Ce circuit a l'avantage de couper les hautes fréquences et d'avoir une réponse en fréquence qui ne tend pas vers une valeur finie. En effet, lorsque la fréquence augmente, la fonction de transfert tend vers zéro. Cependant, du fait de la présence d'un zéro dans la fonction de transfert, ce circuit ne présente pas une courbe de réponse en fréquence du deuxième ordre.

Un besoin existe d'un filtre passe-bas du second ordre présentant une réponse en fréquence améliorée, s'approchant de la fonction de transfert théorique.

<u>Résumé</u>

Un objet d'un mode de réalisation de la présente invention est de prévoir un filtre passe-bas palliant tout ou partie des inconvénients susmentionnés.

Un autre objet d'un mode de réalisation de la présente invention est de prévoir un filtre passe-bas du second ordre dont la fonction de transfert réelle s'approche d'une fonction de transfert théorique.

Ainsi, un mode de réalisation de la présente invention prévoit un filtre passe-bas, comprenant : entre une première borne et une deuxième borne, une association en série d'une première résistance, d'une deuxième résistance et d'un premier amplificateur ; en parallèle sur la deuxième résistance, une association en série d'un deuxième amplificateur et d'un premier condensateur ; un deuxième condensateur entre une entrée du premier amplificateur et une troisième borne d'application d'un potentiel de référence ; et un troisième condensateur entre la deuxième borne et la troisième borne.

Selon un mode de réalisation de la présente invention, le premier et le deuxième amplificateurs présentent un gain unitaire.

Selon un mode de réalisation de la présente invention, le rapport entre les capacités du premier condensateur et du troisième condensateur est égal au rapport entre la résistance de sortie du premier amplificateur et la résistance de sortie du deuxième amplificateur.

Selon un mode de réalisation de la présente invention, les première et deuxième résistances ont des valeurs identiques.

Selon un mode de réalisation de la présente invention, les premier et troisième condensateurs ont des capacités égales.

Selon un mode de réalisation de la présente invention, les premier et deuxième condensateurs présentent des capacités égales, respectivement, à :

$$\frac{1}{2\pi.R.f_0}\sqrt{2\frac{B - A \pm \sqrt{B^2 - 2AB}}{A^2(1 + 2A)}} \quad ;$$

et

$$\frac{1}{2\pi.R.f_0}\sqrt{\frac{1}{2(1 + 2A)}\frac{A^2}{B - A \pm \sqrt{B^2 - 2AB}}} \; ,$$

avec :

$$A = \frac{R_0}{R} \quad \text{et} \quad B = \frac{1 + 2\,R_0/R}{4Q^2} \, ,$$

$R_0$ représentant la valeur de la résistance de sortie de chacun des premier et second amplificateurs, R désignant la valeur des première et deuxième résistances, Q et $f_0$ désignant, respectivement, le facteur de qualité et la fréquence propre du filtre passe-bas.

Selon un mode de réalisation de la présente invention, les valeurs des résistances de sortie des premier et second amplificateurs satisfont à l'inéquation :

$$R_0 \leq R\left(\frac{1}{8Q^2 - 2}\right).$$

Selon un mode de réalisation de la présente invention, les premier et deuxième condensateurs présentent des capacités, respectivement, égales à :

$$\frac{1}{2\pi . R . f_0} \sqrt{2\,\frac{B - A \pm \sqrt{B^2 - 2AB}}{A^2(1 + 2A)}} \quad ;$$

et

$$\frac{1}{2\pi . R . f_0} \sqrt{\frac{1}{2(1 + 2A)}\,\frac{A^2}{B - A \pm \sqrt{B^2 - 2AB}}} \, ,$$

avec :

$$A = \frac{R_0}{R} \quad \text{et} \quad B = \frac{1 + 2\,R_0/R}{4Q^2} \, ,$$

$R_0$ représentant la valeur de la résistance de sortie du second amplificateur, R désignant la valeur des première et deuxième résistances, Q et $f_0$ désignant, respectivement, le facteur de qualité et la fréquence propre du filtre passe-bas.

Selon un mode de réalisation de la présente invention, la valeur de la résistance de sortie du second amplificateur satisfait à l'inéquation :

$$R_0 \leq R\left(\frac{1}{8Q^2 - 2}\right).$$

Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :

la figure 1, précédemment décrite, représente un filtre passe-bas du second ordre de type Sallen-Key ;
la figure 2, précédemment décrite, représente un circuit connu correspondant à une amélioration du filtre de la figure 1 ; et
la figure 3 représente un circuit d'un filtre passe-bas du second ordre selon un mode de réalisation de la présente invention.

Par souci de clarté, de mêmes éléments ont été désignés par de mêmes références aux différentes figures.

Description détaillée

La figure 3 illustre un filtre passe-bas 18 présentant une fonction de transfert du second ordre selon un mode de réalisation de la présente invention.

Le filtre comprend, en série entre une borne d'entrée IN d'une tension d'entrée $V_{in}$ et une borne de sortie OUT d'une tension de sortie $V_{out}$, une première résistance $R_1$, une seconde résistance $R_2$ et un premier buffer 20 dont l'impédance de sortie est résistive et de valeur $R_{01}$ (schématisée entre la sortie du premier buffer 20 et la sortie OUT).

En parallèle sur la seconde résistance $R_2$ est connectée une branche comprenant, en série, un second buffer 22 dont l'impédance de sortie est résistive de valeur $R_{02}$ et un premier condensateur $C_1'$. Entre l'entrée du second buffer 22 et une borne d'application d'un potentiel de référence, par exemple la masse, est connecté un deuxième condensateur $C_2'$ et, entre la sortie OUT et la borne d'application du potentiel de référence (par exemple de masse) est prévu un troisième condensateur $C_3'$.

Pour obtenir un circuit passe-bas présentant une fonction de transfert du second ordre suivant une fonction de transfert théorique, l'inventeur a déterminé des conditions que les premier, deuxième et troisième condensateurs $C_1'$, $C_2'$ et $C_3'$ doivent de préférence satisfaire, dans le cas où les résistances $R_1$ et $R_2$ sont de valeur R et où les résistances de sortie $R_{01}$ et $R_{02}$ sont de valeur $R_0$. On notera que l'homme de l'art déterminera aisément la résistance de sortie des premier et second buffers en fonction des éléments qui les composent.

Dans ce cas, les condensateurs $C_1'$, $C_2'$ et $C_3'$ respectent préférentiellement les relations suivantes :

$$C_1' = \frac{1}{2\pi.R.f_0} \sqrt{2\frac{B - A \pm \sqrt{B^2 - 2AB}}{A^2(1 + 2A)}} \quad ;$$

$$C_2' = \frac{1}{2\pi.R.f_0} \sqrt{\frac{1}{2(1+2A)}\frac{A^2}{B - A \pm \sqrt{B^2 - 2AB}}} \quad ;$$

et

$$C_3' = C_1' ,$$

avec :

$$A = \frac{R_0}{R} \text{ et } B = \frac{1 + 2R_0/R}{4Q^2} ,$$

$f_0$ et Q désignant, respectivement, la fréquence propre et le facteur de qualité souhaités du filtre, en accord avec l'équation générale d'un circuit passe bas du second ordre :

$$T = \frac{Vout}{Vin} = \frac{1}{1 + \frac{1}{Q}\left(\frac{j\omega}{\omega_0}\right) + \left(\frac{j\omega}{\omega_0}\right)^2} , \quad f_0 = \frac{\omega_0}{2\pi} .$$

De plus, les équations ci-dessus impliquent une condition supplémentaire pour que le circuit fonctionne correctement. Il faut que la résistance de sortie $R_0$ des premier et second buffers satisfasse à l'inéquation suivante :

$$R_0 \leq R\left(\frac{1}{8Q^2 - 2}\right).$$

Ainsi, pour une valeur donnée du facteur de qualité du filtre, la valeur $R_0$ de la résistance de sortie du buffer doit être inférieure à la valeur ci-dessus.

Un circuit répondant aux exigences ci-dessus suit une fonction de transfert idéale du deuxième ordre, présentant, à fréquence élevée, une asymptote du second ordre (-40dB/décade).

De plus, l'inventeur a montré que, si les résistances de sortie $R_{01}$ et $R_{02}$ ne sont pas égales, par exemple si $R_{02} = R_0$ et $R_{01} = R_0/D$, D étant un nombre positif, il suffit de modifier la valeur de la troisième capacité $C_3'$, et de la fixer à une valeur $C_3'' = D.C_3' = D.C_1'$ pour que le circuit fonctionne de nouveau correctement, à savoir comme un filtre passe-bas du second ordre théorique.

Si l'on souhaite obtenir un circuit passe-bas d'un ordre plus élevé que le deuxième ordre, on pourra utiliser plusieurs circuits tels que le circuit 18 en série.

Des modes de réalisation particuliers de la présente invention ont été décrits. Diverses variantes et modifications apparaîtront à l'homme de l'art. En particulier, on a décrit ici un circuit comprenant des buffers 20 et 22 de gains égaux et unitaires. On notera que les buffers 20 et 22 pourront présenter des gains distincts et/ou non unitaires. Dans ce cas, l'homme de l'art modifiera aisément les équations ci-dessus pour obtenir un filtre passe-bas du second ordre idéal. De plus, on a décrit le circuit de la figure 3 avec des résistances $R_1$ et $R_2$ de mêmes valeurs. On pourra également prévoir un circuit comprenant des résistances $R_1$ et $R_2$ de valeurs distinctes, en adaptant les valeurs des autres éléments.

## Revendications

1.   Filtre passe-bas, comprenant :

   entre une première borne (IN) et une deuxième borne (OUT), une association en série d'une première résistance (R1), d'une deuxième résistance (R2) et d'un premier amplificateur (20) ;
   en parallèle sur la deuxième résistance, une association en série d'un deuxième amplificateur (22) et d'un premier condensateur ($C_1'$) ;
   un deuxième condensateur ($C_2'$) entre une entrée du premier amplificateur et une troisième borne d'application d'un potentiel de référence ; et
   un troisième condensateur ($C_3'$) entre la deuxième borne (OUT) et la troisième borne.

2.   Filtre selon la revendication 1, dans lequel les premier et deuxième amplificateurs (20, 22) présentent un gain unitaire.

3.   Filtre selon la revendication 1 ou 2, dans lequel le rapport entre les capacités du premier condensateur ($C_1'$) et du troisième condensateur ($C_3'$) est égal au rapport entre la résistance de sortie ($R_{01}$) du premier amplificateur (20) et la résistance de sortie ($R_{02}$) du deuxième amplificateur (22).

4.   Filtre selon l'une quelconque des revendications 1 à 3, dans lequel les première et deuxième résistances ($R_1$, $R_2$) ont des valeurs identiques.

5.   Filtre selon la revendication 4, dans lequel les premier et troisième condensateurs ($C_1'$, $C_3'$) ont des capacités égales.

6.   Filtre selon la revendication 5, dans lequel les premier et deuxième condensateurs ($C_1'$, $C_2'$) présentent des capacités égales, respectivement, à :

$$\frac{1}{2\pi.R.f_0}\sqrt{2\frac{B - A \pm \sqrt{B^2 - 2AB}}{A^2(1 + 2A)}} \quad ;$$

et

$$\frac{1}{2\pi.R.f_0} \sqrt{\frac{1}{2(1+2A)} \frac{A^2}{B-A\pm\sqrt{B^2-2AB}}} \ ,$$

avec :

$$A = \frac{R_0}{R} \quad \text{et} \quad B = \frac{1+2\,R_0/R}{4Q^2} \ ,$$

$R_0$ représentant la valeur de la résistance de sortie de chacun des premier et second amplificateurs (20, 22), R désignant la valeur des première et deuxième résistances ($R_1$, $R_2$), Q et $f_0$ désignant, respectivement, le facteur de qualité et la fréquence propre du filtre passe-bas.

7.  Filtre selon la revendication 6, dans lequel les valeurs des résistances de sortie ($R_0$) des premier et second amplificateurs (20, 22) satisfont à l'inéquation :

$$R_0 \le R\left(\frac{1}{8Q^2-2}\right).$$

8.  Filtre selon la revendication 4, dans lequel les premier et deuxième condensateurs ($C_1$', $C_2$') présentent des capacités, respectivement, égales à :

$$\frac{1}{2\pi.R.f_0} \sqrt{2\frac{B-A\pm\sqrt{B^2-2AB}}{A^2(1+2A)}} \quad ;$$

et

$$\frac{1}{2\pi.R.f_0} \sqrt{\frac{1}{2(1+2A)} \frac{A^2}{B-A\pm\sqrt{B^2-2AB}}} \ ,$$

avec :

$$A = \frac{R_0}{R} \quad \text{et} \quad B = \frac{1+2\,R_0/R}{4Q^2} \ ,$$

$R_0$ représentant la valeur de la résistance de sortie du second amplificateur (22), R désignant la valeur des première et deuxième résistances ($R_1$, $R_2$), Q et $f_0$ désignant, respectivement, le facteur de qualité et la fréquence propre du filtre passe-bas.

9.  Filtre selon la revendication 8, dans lequel la valeur de la résistance de sortie du second amplificateur (22) satisfait à l'inéquation :

$$R_0 \le R\left(\frac{1}{8Q^2 - 2}\right).$$

## Claims

1. A low-pass filter, comprising:

   between a first terminal (IN) and a second terminal (OUT), a series association of a first resistor ($R_1$), a second resistor ($R_2$), and a first amplifier (20);
   in parallel with the second resistor, a series association of a second amplifier (22) and a first capacitor ($C_1$');
   a second capacitor ($C_2$') between an input of the first amplifier and a third terminal of application of a reference voltage; and
   a third capacitor ($C_3$') between the second terminal (OUT) and the third terminal.

2. The filter of claim 1, wherein the first and second amplifiers (20, 22) have a unity gain.

3. The filter of claim 1 or 2, wherein the ratio between the capacitances of the first capacitor ($C_1$') and of the third capacitor ($C_3$') is equal to the ratio between the output resistance ($R_{01}$) of the first amplifier (20) and the output resistance ($R_{02}$) of the second amplifier (22).

4. The filter of any of claims 1 to 3, wherein the first and second resistors ($R_1$, $R_2$) have identical values.

5. The filter of claim 4, wherein the first and third capacitors ($C_1$', $C_3$') have equal capacitances.

6. The filter of claim 5, wherein the first and second capacitors ($C_1$', $C_2$') have capacitances respectively equal to:

$$\frac{1}{2\pi.R.f_0}\sqrt{2\frac{B - A \pm \sqrt{B^2 - 2AB}}{A^2(1 + 2A)}} \; ;$$

and

$$\frac{1}{2\pi.R.f_0}\sqrt{\frac{1}{2(1 + 2A)}\frac{A^2}{B - A \pm \sqrt{B^2 - 2AB}}} \; ,$$

with:

$$A = \frac{R_0}{R} \quad \text{and} \quad B = \frac{1 + 2R_0/R}{4Q^2} \; ,$$

$R_0$ standing for the value of the output resistance of each of the first and second amplifiers (20, 22), R designating the value of the first and second resistors ($R_1$, $R_2$), Q and $f_0$ respectively designating the quality factor and the natural frequency of the low-pass filter.

7. The filter of claim 6, wherein the values of the output resistances ($R_0$) of the first and second amplifiers (20, 22) comply with the following inequation:

$$R_0 \le R\left(\frac{1}{8Q^2 - 2}\right).$$

**8.** The filter of claim 4, wherein the first and second capacitors ($C_1'$, $C_2'$) have capacitances respectively equal to:

$$\frac{1}{2\pi.R.f_0}\sqrt{2\frac{\overline{B} - \overline{A} \pm \sqrt{B^2 - 2AB}}{A^2(1+2A)}} \ ;$$

and

$$\frac{1}{2\pi.R.f_0}\sqrt{\frac{1}{2(1+2A)}\frac{A^2}{B - A \pm \sqrt{B^2 - 2AB}}} \ ,$$

with:

$$A = \frac{R_0}{R} \quad \text{and} \quad B = \frac{1 + 2R_0/R}{4Q^2} \ ,$$

$R_0$ standing for the value of the output resistance of the second amplifier (22), R designating the value of the first and second resistors ($R_1$, $R_2$), Q and $f_0$ respectively designating the quality factor and the natural frequency of the low-pass filter.

**9.** The filter of claim 8, wherein the value of the output resistance of the second amplifier (22) complies with the following inequation:

$$R_0 \le R\left(\frac{1}{8Q^2 - 2}\right).$$

**Patentansprüche**

**1.** Ein Tiefpassfilter, der Folgendes aufweist:

zwischen einem ersten Anschluss (IN) und einem zweiten Anschluss (OUT), eine Reihenschaltung eines ersten Widerstands ($R_1$), mit einem zweiten Widerstand ($R_2$) und einem ersten Verstärker (20);
parallel zu dem zweiten Widerstand eine Reihenschaltung von einem zweiten Verstärker (22) und einem ersten Kondensator (C');
einen zweiten Kondensator ($C_2'$) zwischen einem Eingang des ersten Verstärkers und einem dritten Anschluss zum Anlegen einer Referenzspannung; und
einen dritten Kondensator ($C_3'$) zwischen dem zweiten Anschluss (OUT) und dem dritten Anschluss.

**2.** Der Filter nach Anspruch 1, wobei der erste und der zweite Verstärker (20, 22) eine unitäre Verstärkung aufweisen.

**3.** Der Filter nach Anspruch 1 oder 2, wobei das Verhältnis der Kapazitäten des ersten Kondensators ($C_1'$) und des dritten Kondensators ($C_3'$) gleich dem Verhältnis zwischen dem Ausgangswiderstand ($R_{01}$) des ersten Verstärkers (20) und dem Ausgangswiderstand ($R_{02}$) des zweiten Verstärkers (22) ist.

4. Der Filter nach Anspruch 1 bis 3, wobei der erste und der zweite Widerstand ($R_1$, $R_2$) identische Werte aufweisen.

5. Der Filter nach Anspruch 4, wobei der erste und dritte Kondensator ($C_1'$, $C_3'$) gleiche Kapazitäten aufweisen.

6. Der Filter nach Anspruch 5, wobei der erste und zweite Kondensator ($C_1'$, $C_2'$) Kapazitäten aufweisen entsprechend den folgenden Gleichungen:

$$\frac{1}{2\pi.R.f_0}\sqrt{2\frac{B-A\pm\sqrt{B^2-2AB}}{A^2(1+2A)}} \quad ;$$

und

$$\frac{1}{2\pi.R.f_0}\sqrt{\frac{1}{2(1+2A)}\frac{A^2}{B-A\pm\sqrt{B^2-2AB}}}$$

mit:

$$A=\frac{R_0}{R} \quad \text{und} \quad B=\frac{1+2R_0/R}{4Q^2} \quad ,$$

wobei $R_0$ für den Wert des Ausgangswiderstands sowohl des ersten als auch des zweiten Verstärkers (20, 22) steht, R den Wert des ersten und zweiten Widerstands ($R_1$, $R_2$) bezeichnet und Q und $f_0$ entsprechend den Gütefaktor und die Eigenfrequenz des Tiefpassfilters bezeichnen.

7. Der Filter nach Anspruch 6, wobei die Werte der Ausgangswiderstände ($R_0$) des ersten und des zweiten Verstärkers (20, 22) der folgenden Ungleichung entsprechen:

$$R_0 \leq R\left(\frac{1}{8Q^2-2}\right) .$$

8. Der Filter nach Anspruch 4, wobei der erste und zweite Kondensator ($C_1'$, $C_2'$) Kapazitäten aufweisen, die den folgenden Gleichungen entsprechen:

$$\frac{1}{2\pi.R.f_0}\sqrt{2\frac{B-A\pm\sqrt{B^2-2AB}}{A^2(1+2A)}} \quad ;$$

und

$$\frac{1}{2\pi.R.f_0}\sqrt{\frac{1}{2(1+2A)}\frac{A^2}{B-A\pm\sqrt{B^2-2AB}}} \; ,$$

mit:

$$A=\frac{R_0}{R} \quad \text{und} \quad B=\frac{1+2\,R_0/R}{4Q^2} \; ,$$

wobei $R_0$ für den Wert des Ausgangswiderstands des zweiten Verstärkers (22) steht, R den Wert des ersten und zweiten Widerstands ($R_1$, $R_2$) bezeichnet und Q und $f_0$ entsprechend den Gütefaktor und die Eigenfrequenz des Tiefpassfilters bezeichnen.

9. Der Filter nach Anspruch 8, wobei der Wert des Ausgangswiderstands des zweiten Verstärkers (22) der folgenden Ungleichung entspricht:

$$R_0 \le R\left(\frac{1}{8Q^2-2}\right) .$$

Fig 1

Fig 2

Fig 3